# EUROPÄISCHE PATENTANMELDUNG

(11) **EP 4 131 697 A1**
(43) Veröffentlichungstag der Anmeldung: **08.02.2023**
(21) Anmeldenummer: 22187926.5
(22) Anmeldetag: 29.07.2022
(51) Int. Cl.: H02J 1/08, H03K 17/96, B60L 53/53, B60L 53/57, H02J 7/34

(54) **MOBILE ELEKTRISCHE ENERGIEBEREITSTELLUNGSVORRICHTUNG**

(30) Priorität: 02.08.2021 DE 102021120050
(71) Anmelder: ads-tec Energy GmbH, 72622 Nürtingen (DE)
(72) Erfinder: RAHMOUN, Ahmad, 72574 Bad Urach (DE); ZIEGLER, Daniel, 72762 Reutlingen (DE)
(74) Vertreter: Kordel, Mattias

(57) **Zusammenfassung**

Die Erfindung betrifft Mobile elektrische Energiebereitstellungsvorrichtung (1), mit
- mindestens einem Energieversorgungsanschluss (3) zur Entnahme von Energie aus der Energiebereitstellungsvorrichtung (1),
- einer Bodenerdungsvorrichtung (5), die eingerichtet ist, um an einem Aufstellort (7) der Energiebereitstellungsvorrichtung (1) mit einem Boden (9) des Aufstellorts (7) zusammenzuwirken, um eine Erdung für die Energiebereitstellungsvorrichtung (1) bereitzustellen, und mit
- einer Berührsicherheits-Überwachungsvorrichtung (13), die eingerichtet ist, um mindestens eine an der Energiebereitstellungsvorrichtung (1) angeordnete oder mit der Energiebereitstellungsvorrichtung (1) elektrisch verbundene Berührstelle (15) auf Berührsicherheit zu überwachen.

## Beschreibung

Die Erfindung betrifft eine mobile elektrische Energiebereitstellungsvorrichtung.

Solche mobilen elektrischen Energiebereitstellungsvorrichtungen sollen auch an Orten, an denen kein oder nur ein beschränkter Zugang zu einem elektrischen Energieversorgungsnetz vorhanden ist, elektrische Energie insbesondere für Verbraucher bereitstellen. Beispielsweise wird mit zunehmender Elektrifizierung des Straßenverkehrs Bedarf dafür bestehen, bei nur temporär stattfindenden Ereignissen oder Veranstaltungen wie beispielsweise Jahrmärkten, Festivals, oder auf Baustellen oder dergleichen, Parkplätze mit Ladeinfrastruktur für elektrische Fahrzeuge bereitzustellen, wobei die Ladeinfrastruktur kurzfristig bereitgestellt und anschließend wieder entfernt werden kann. In solchen Fällen können mobile elektrische Energiebereitstellungsvorrichtungen aufgestellt, bei Bedarf getauscht, und nach dem Ereignis wieder entfernt werden. Problematisch ist dabei, dass an einer Vielzahl möglicher Aufstellorte für solche Energiebereitstellungsvorrichtungen keine Möglichkeit besteht, eine Erdung über eine Haupterdungsschiene, einen Fundamenterder, einen Tiefenerder oder dergleichen sicherzustellen. Gleichwohl muss gewährleistet sein, dass eine Berührung von für Benutzer zugänglichen Bereichen der Energiebereitstellungsvorrichtung zu jedem Zeitpunkt gefahrlos möglich ist.

Der Erfindung liegt daher die Aufgabe zugrunde, eine mobile elektrische Energiebereitstellungsvorrichtung zu schaffen, bei der die genannten Nachteile zumindest reduziert sind, vorzugsweise nicht auftreten.

Die Aufgabe wird gelöst, indem die vorliegende technische Lehre bereitgestellt wird, insbesondere die Lehre der unabhängigen Ansprüche sowie der in den abhängigen Ansprüchen und der Beschreibung offenbarten Ausführungsformen.

Die Aufgabe wird insbesondere gelöst, indem eine mobile elektrische Energiebereitstellungsvorrichtung geschaffen wird, die mindestens einen Energieversorgungsanschluss zur Entnahme von Energie aus der Energiebereitstellungsvorrichtung und eine Bodenerdungsvorrichtung aufweist, wobei die Bodenerdungsvorrichtung eingerichtet ist, um an einem Aufstellort der Energiebereitstellungsvorrichtung mit einem Boden des Aufstellorts zusammenzuwirken, um eine Erdung für die Energiebereitstellungsvorrichtung bereitzustellen. Die Energiebereitstellungsvorrichtung weist außerdem eine Berührsicherheits-Überwachungsvorrichtung auf, die eingerichtet ist, um mindestens eine an der Energiebereitstellungsvorrichtung angeordnete oder mit der Energiebereitstellungsvorrichtung elektrisch verbundene Berührstelle auf Berührsicherheit zu überwachen. Mittels der Berührsicherheits-Überwachungsvorrichtung kann vorteilhaft eine Berührsicherheit der mindestens einen Berührstelle dauerhaft gewährleistet werden, sodass Benutzer der Energiebereitstellungsvorrichtung keiner Gefahr ausgesetzt sind, Schäden durch zu hohe elektrische Spannungen und/oder Ströme zu erleiden. Die Energiebereitstellungsvorrichtung kann somit vorteilhaft auch an solchen Aufstellorten aufgestellt und betrieben werden, die keine Möglichkeit bieten, einen Erdschluss oder Potentialausgleich über eine Haupterdungsschiene, einen Fundamenterder, einen Tiefenerder oder dergleichen bereitzustellen.

Unter einer mobilen elektrischen Energiebereitstellungsvorrichtung wird im Kontext der vorliegenden technischen Lehre insbesondere eine Vorrichtung verstanden, die eingerichtet ist, um elektrische Energie, insbesondere für einen Verbraucher, bereitzustellen, und die außerdem mobil, das heißt insbesondere transportierbar, ausgebildet ist. Insbesondere ist die mobile elektrische Energiebereitstellungsvorrichtung so eingerichtet, dass sie auf einen Lastkraftwagen, insbesondere auf eine Ladefläche eines Transporters, aufgeladen und transportiert werden kann. Es besteht aber keine grundsätzliche Größenbeschränkung für die Energiebereitstellungsvorrichtung, solange deren Transportierbarkeit grundsätzlich gewährleistet ist. Es ist also auch denkbar, dass die Energiebereitstellungsvorrichtung - quasi am einen Ende der Größenskala - im Wege eines Spezialtransports mit Sondergenehmigung transportierbar ist, oder dass sie - quasi am anderen Ende der Größenskala - in einem Personenkraftwagen transportiert werden kann. In bevorzugter Ausgestaltung ist die Energiebereitstellungsvorrichtung so dimensioniert, dass genau sechs Exemplare der Energiebereitstellungsvorrichtung auf einer Ladefläche eines Lastkraftwagens mit einem zulässigen Gesamtgewicht von 7,5 t transportiert werden können. In einer Ausführungsform weist die Energiebereitstellungsvorrichtung eine Höhe von 2200 mm bis 2600 mm, vorzugsweise von 2280 mm bis 2520 mm, vorzugsweise 2400 mm, eine Breite von 1000 mm bis 1400 mm, vorzugsweise von 1140 mm bis 1260 mm, vorzugsweise 1200 mm, und eine Tiefe von 1300 mm bis 1700 mm, vorzugsweise von 1425 mm bis 1575 mm, vorzugsweise 1500 mm, auf.

Die Energiebereitstellungsvorrichtung ist insbesondere so eingerichtet, dass sie an dem Aufstellort lediglich abgestellt oder hingestellt wird, wobei sie insbesondere nicht elektrisch an ein Versorgungsnetz, eine Haupterdungsschiene, einen Fundamenterder, einen Tiefenerder oder dergleichen angeschlossen wird. Insbesondere ist die Energiebereitstellungsvorrichtung als fliegender Bau ausgebildet. Dem steht nicht entgegen, dass die Energiebereitstellungsvorrichtung gegebenenfalls an dem Aufstellort mechanisch - insbesondere gegen Diebstahl oder Elementarereignisse oder dergleichen - gesichert werden kann, beispielsweise mittels Erdnägeln oder dergleichen.

In einer Ausführungsform ist die mobile elektrische Energiebereitstellungsvorrichtung eingerichtet, um eine elektrische Leistung von 2 kW bis 1 MW, vorzugsweise von 3,7 kW bis 500 kW, vorzugsweise von 11 kW bis 350 kW, vorzugsweise von 20 kW bis 250 kW, vorzugsweise von 22 kW bis 150 kW, vorzugsweise von 43 kW bis 100 kW, vorzugsweise 100 kW, bereitzustellen.

Alternativ oder zusätzlich ist die mobile elektrische Energiebereitstellungsvorrichtung bevorzugt eingerichtet, um eine elektrische Energie von 20 kWh bis 1 MWh, vorzugsweise von 30 kWh bis 500 kWh, vorzugsweise von 40 kWh bis 200 kWh, vorzugsweise von 50 kWh bis 100 kWh, vorzugsweise von 60 kWh bis 90 kWh, vorzugsweise von 70 Wh bis 80 kWh, bereitzustellen.

Unter einem Energieversorgungsanschluss wird im Kontext der vorliegenden technischen Lehre ein elektrischer Anschluss verstanden, der eingerichtet ist, um eine elektrische Verbindung zwischen der Energiebereitstellungsvorrichtung und einer anderen elektrischen Vorrichtung, insbesondere einem Verbraucher, beispielsweise einer Batterie, einer elektrischen Schaltung oder einer elektrischen Maschine, herzustellen, sodass der elektrischen Vorrichtung über die elektrische Verbindung elektrische Energie aus der Energiebereitstellungsvorrichtung zugeführt werden kann. Der Energieversorgungsanschluss kann insbesondere als Anschlussdose, als Ladekabel, insbesondere mit angeschlossenem Ladestecker, oder in anderer geeigneter Weise ausgebildet sein.

Unter einem Aufstellort wird im Kontext der vorliegenden technischen Lehre insbesondere ein geographischer Ort verstanden, an dem die Energiebereitstellungsvorrichtung insbesondere zu dem Zweck ihrer Verwendung zur Bereitstellung von elektrische Energie aufgestellt wird. Unter einem Boden des Aufstellorts wird insbesondere ein Flächenbereich an dem Aufstellort verstanden, auf dem die Energiebereitstellungsvorrichtung schwerkraftbedingt aufsteht, wobei die Energiebereitstellungsvorrichtung bevorzugt in unmittelbarem berührendem Kontakt zu dem Boden ist, wenn sie an dem Aufstellort auf dem Boden aufgestellt ist.

Unter einer Berührstelle wird im Kontext der vorliegenden technischen Lehre insbesondere eine für einen Benutzer der elektrischen Energiebereitstellungsvorrichtung oder einen Dritten zugängliche Stelle verstanden, die elektrisch leitend, insbesondere galvanisch, mit der Energiebereitstellungsvorrichtung verbunden oder an der Energiebereitstellungsvorrichtung selbst angeordnet ist, insbesondere eine Stelle, von der nicht kategorisch ausgeschlossen werden kann, dass ein Benutzer oder ein Dritter in berührenden Kontakt mit ihr kommt. Die Berührstelle kann an der Energiebereitstellungsvorrichtung selbst, insbesondere an einem Gehäuse der Energiebereitstellungsvorrichtung, angeordnet sein, sie kann aber insbesondere auch an einer mit der Energiebereitstellungsvorrichtung elektrisch leitend verbundenen Vorrichtung, beispielsweise einem mit der Energiebereitstellungsvorrichtung elektrisch verbundenen Kraftfahrzeug, angeordnet sein.

Unter Berührsicherheit wird im Kontext der vorliegenden technischen Lehre insbesondere verstanden, dass die Berührstelle durch den Benutzer berührt werden kann, ohne dass die Gefahr einer Beeinträchtigung oder Schädigung des Benutzers durch eine zu hohe Spannung und/oder einen zu hohen Strom besteht.

Wo im vorliegenden Text von einer Spannung oder einem Strom beziehungsweise einer Stromstärke die Rede ist, ist stets eine elektrische Spannung oder ein elektrischer Strom beziehungsweise eine elektrische Stromstärke gemeint, wenn nicht ausdrücklich etwas anderes angegeben ist.

Insbesondere ist die Berührsicherheits-Überwachungsvorrichtung eingerichtet, um die Berührsicherheit zu bewerten, insbesondere um festzustellen, ob die Berührsicherheit gegeben ist, oder ob die Berührsicherheit nicht gegeben ist.

In einer Ausführungsform der Energiebereitstellungsvorrichtung ist die Berührsicherheits-Überwachungsvorrichtung eingerichtet, um mindestens eine Maßnahme zu ergreifen, wenn festgestellt wird, dass die Berührsicherheit nicht gegeben ist. Die mindestens eine Maßnahme ist bevorzugt ausgewählt aus einer Gruppe, bestehend aus: Einem Abschalten der Energiebereitstellungsvorrichtung, insbesondere einer Leistungselektronik der Energiebereitstellungsvorrichtung, einem Auslösen eines Hardware-Fehlers, und einem Öffnen eines Hauptschalters der Energiebereitstellungsvorrichtung, insbesondere eines Hauptschalters der Leistungselektronik. Wird ein Hardware-Fehler ausgelöst, führt dies bevorzugt ebenfalls zum Abschalten der Energiebereitstellungsvorrichtung und/oder zum Öffnen des Hauptschalters.

Gemäß einer Weiterbildung der Erfindung ist vorgesehen, dass die Bodenerdungsvorrichtung mindestens eine Erdungs-Standfläche aufweist, die angeordnet und eingerichtet ist, um an dem Aufstellort in berührendem Kontakt mit dem Boden zu sein, insbesondere auf dem Boden aufzustehen. Über die Erdungs-Standfläche wird vorteilhaft ein Potentialausgleich zu dem Boden bereitgestellt. Insbesondere ist die mindestens eine Erdungs-Standfläche derart angeordnet und eingerichtet, dass die Energiebereitstellungsvorrichtung mit der mindestens einen Erdung-Standfläche an dem Aufstellort auf dem Boden aufsteht.

In einer Ausführungsform ist die Erdungs-Standfläche an einer Erdungsplatte, insbesondere einer elektrisch leitfähigen Platte, insbesondere einer Metallplatte, angeordnet, oder sie ist als Erdungsplatte, insbesondere als elektrisch leitfähige Platte, insbesondere als Metallplatte ausgebildet.

In einer Ausführungsform der Energiebereitstellungsvorrichtung weist die mindestens eine Erdungs-Standfläche eine Fläche von 1000 cm² bis 5000 cm², vorzugsweise 2000 cm² bis 4000 cm² auf. Bevorzugt weist die Bodenerdungsvorrichtung eine Mehrzahl von Erdungs-Standflächen auf, wobei die Erdungs-Standflächen insgesamt eine Fläche von 3000 cm² bis 6000 cm², vorzugsweise 4000 cm², aufweisen. Weist die Bodenerdungsvorrichtung eine Mehrzahl von Erdungs-Standflächen auf, sind diese bevorzugt so angeordnet, dass die Energiebereitstellungsvorrichtung mit mindestens zwei Erdungs-Standflächen der Mehrzahl von Erdungs-Standflächen, vorzugsweise mit allen Erdungs-Standflächen, auf dem Boden des Aufstellorts aufsteht.

In einer Ausführungsform der Energiebereitstellungsvorrichtung weist die Bodenerdungsvorrichtung genau zwei Erdungs-Standflächen auf, wobei jede Erdungs-Standfläche der zwei Erdungs-Standflächen eine Fläche von ca. 2000 cm², insbesondere 1900 cm² bis 2100 cm², vorzugsweise 2000 cm², aufweist, sodass die beiden Erdungs-Standflächen insgesamt eine Fläche von ca. 4000 cm², insbesondere 3800 cm² bis 4200 cm², vorzugsweise 4000 cm² aufweisen.

Gemäß einer Weiterbildung der Erfindung ist vorgesehen, dass die Berührsicherheits-Überwachungsvorrichtung mindestens eine Kontaktplatte aufweist, die angeordnet und eingerichtet ist, um an dem Aufstellort in berührendem Kontakt mit dem Boden zu sein. Mittels der mindestens einen Kontaktplatte kann vorteilhaft insbesondere eine elektrische Verbindung eines Benutzers zu dem Boden des Aufstellorts nachgebildet werden. Die mindestens eine Kontaktplatte ist insbesondere zusätzlich zu der mindestens einen Erdungs-Standfläche vorgesehen. Insbesondere ist die mindestens eine Kontaktplatte von der Erdungs-Standfläche beabstandet angeordnet, sodass die Kontaktplatte die Erdungs-Standfläche nicht berührt. Die mindestens eine Kontaktplatte ist insbesondere in einem Bodenbereich der Energiebereitstellungsvorrichtung angeordnet.

In einer Ausführungsform weist die mindestens eine Kontaktplatte eine Fläche von 100 cm² bis 500 cm², vorzugsweise 200 cm² bis 400 cm² auf. Bevorzugt weist die Berührsicherheits-Überwachungsvorrichtung eine Mehrzahl von Kontaktplatten auf, wobei die Kontaktplatten insgesamt eine Fläche von 300 cm² bis 600 cm², vorzugsweise 400 cm², aufweisen. Weist die Berührsicherheits-Überwachungsvorrichtung eine Mehrzahl von Kontaktplatten auf, sind diese bevorzugt so angeordnet, dass die Energiebereitstellungsvorrichtung mit mindestens zwei Kontaktplatten der Mehrzahl von Kontaktplatten, vorzugsweise mit allen Kontaktplatten, in berührendem Kontakt mit dem Boden an dem Aufstellort ist, wenn die Energiebereitstellungsvorrichtung an dem Aufstellort aufgestellt ist.

Die mindestens eine Kontaktplatte ist bevorzugt so angeordnet und eingerichtet, dass sie mit einer - insbesondere vorbestimmten - Kraft von 200 N bis 300 N, vorzugsweise 250 N, gegen den Boden gedrängt wird, wenn die Energiebereitstellungsvorrichtung an dem Aufstellort aufgestellt ist. In einer Ausführungsform der Energiebereitstellungsvorrichtung ist die mindestens eine Kontaktplatte aktiv oder passiv vorgespannt, beispielweise mittels einer Feder und/oder durch einen Aktor, um zu gewährleisten, dass sie mit der vorbestimmten Kraft gegen den Boden gedrängt wird, insbesondere unabhängig von der konkreten Beschaffenheit des Bodens an dem Aufstellort. Alternativ oder zusätzlich weist die mindestens eine Kontaktplatte eine Masse von 20 kg bis 30 kg, vorzugsweise 25 kg, auf.

Die mindestens eine Kontaktplatte bildet bevorzugt menschliche Füße eines Benutzers der Energiebereitstellungsvorrichtung an dem Aufstellort nach, sodass die Berührsicherheit eines Benutzers mittels der Berührsicherheits-Überwachungsvorrichtung an dem Aufstellort unter realistischen Bedingungen überwacht werden kann.

In einer Ausführungsform der Energiebereitstellungsvorrichtung weist die Berührsicherheits-Überwachungsvorrichtung eine Messvorrichtung auf, die einerseits mit der mindestens einen Kontaktplatte und andererseits mit der mindestens einen Berührstelle wirkverbunden ist. Insbesondere ist die Messvorrichtung einerseits mit der mindestens einen Kontaktplatte und andererseits mit der mindestens einen Berührstelle elektrisch verbunden. Insbesondere auf diese Weise kann vorteilhaft eine elektrische Verbindung der Berührstelle mit dem Boden über einen Benutzer mittels der Kontaktplatte nachgebildet werden, wobei die Messvorrichtung es erlaubt, die Berührsicherheit, insbesondere auftretende Ströme und/oder Spannungen, zu erfassen und vorzugsweise zu bewerten.

Gemäß einer Weiterbildung der Erfindung ist vorgesehen, dass die Messvorrichtung eingerichtet ist, um mindestens eine elektrische Messgröße zwischen der mindestens einen Berührstelle und der mindestens einen Kontaktplatte zu messen, wobei die mindestens eine elektrische Messgröße ausgewählt ist aus einer Gruppe, bestehend aus einer Spannung und einer Stromstärke. Insbesondere auf diese Weise kann vorteilhaft - quasi stellvertretend für einen Benutzer, also gleichsam als Proxy-Messung - die Berührsicherheit über die relevanten elektrischen Größen bewertet werden, die zwischen der mindestens einen Berührstelle und der mindestens einen Kontaktplatte auftreten.

In einer Ausführungsform der Energiebereitstellungsvorrichtung ist die Messvorrichtung eingerichtet, um nur die Spannung als elektrische Messgröße zu messen. In einer anderen Ausführungsform der Energiebereitstellungsvorrichtung ist die Messvorrichtung eingerichtet, um nur die Stromstärke als elektrische Messgröße zu messen. In wieder einer anderen Ausführungsform der Energiebereitstellungsvorrichtung ist die Messvorrichtung eingerichtet, um sowohl die Spannung als auch die Stromstärke als elektrische Messgrößen zu messen; dies kann eine Redundanz bedeuten, wobei aber die verschiedenen elektrische Messgrößen vorteilhaft eine Plausibilisierung der Messungen gegeneinander erlauben.

In einer Ausführungsform der Energiebereitstellungsvorrichtung ist die Messvorrichtung eingerichtet, um die mindestens eine elektrische Messgröße passiv zu messen. In einer anderen Ausführungsform der Energiebereitstellungsvorrichtung ist die Messvorrichtung eingerichtet, um die mindestens eine elektrische Messgröße aktiv zu messen, insbesondere durch Aufprägen eines Signals, insbesondere eines Wechselstromsignals (AC-Signal).

In einer Ausführungsform der Energiebereitstellungsvorrichtung ist die Messvorrichtung eingerichtet, um die mindestens eine elektrische Messgröße als Gleichstromgröße (DC) zu messen. In einer anderen Ausführungsform der Energiebereitstellungsvorrichtung ist die Messvorrichtung eingerichtet, um die mindestens eine elektrische Messgröße als Wechselstromgröße (AC) zu messen. In einer anderen Ausführungsform der Energiebereitstellungsvorrichtung ist die Messvorrichtung eingerichtet, um als die mindestens eine elektrische Messgröße eine erste elektrische Messgröße als Gleichstromgröße und eine zweite elektrische Messgröße als Wechselstromgröße zu erfassen. In einer anderen Ausführungsform der Energiebereitstellungsvorrichtung ist die Messvorrichtung eingerichtet, um die mindestens eine elektrische Messgröße als Gleichstromgröße und als Wechselstromgröße, insbesondere als Kombination aus einer Gleichstromgröße und einer Wechselstromgröße, zu erfassen.

Gemäß einer Weiterbildung der Erfindung ist vorgesehen, dass die Berührsicherheits-Überwachungsvorrichtung eingerichtet ist, um einen Messwert der mindestens einen elektrischen Messgröße mit einem Schwellenwert zu vergleichen, und um die Berührsicherheit anhand des Vergleichs zu bewerten. Der Schwellenwert ist dabei bevorzugt vorteilhaft so gewählt, dass die Berührsicherheit gegeben ist, wenn der Messwert der mindestens einen elektrischen Messgröße den Schwellenwert unterschreitet. Der Schwellenwert kann insbesondere eine Grenz-Spannung oder eine Grenz-Stromstärke sein.

Bevorzugt ist für jede elektrische Messgröße, insbesondere für die Spannung und für die Stromstärke, jeweils ein separater Schwellenwert vorgegeben. Es ist also insbesondere mindestens ein Schwellenwert vorgesehen, vorzugsweise für jede elektrische Messgröße ein separater Schwellenwert.

In einer Ausführungsform der Energiebereitstellungsvorrichtung ist vorgesehen, dass der mindestens eine Schwellenwert fest vorgegeben ist.

In einer anderen Ausführungsform der Energiebereitstellungsvorrichtung ist vorgesehen, dass die Berührsicherheits-Überwachungsvorrichtung eingerichtet ist, um den mindestens einen Schwellenwert insbesondere in Abhängigkeit von wenigstens einem Aufstellungsparameter zu wählen, insbesondere zu variieren, wobei der wenigstens eine Aufstellungsparameter vorzugsweise ausgewählt aus einer Gruppe, bestehend aus: Einer Impedanz oder einem elektrischen Widerstand des Bodens an dem Aufstellungsort, einer chemischen Zusammensetzung des Bodens, einer physikalischen Beschaffenheit des Bodens, einer Feuchte oder einem Wassergehalt des Bodens, und einer Bodenebenheit an dem Aufstellort. Die Impedanz oder der elektrische Widerstand des Bodens beeinflussen unmittelbar die Berührsicherheit und damit eine geeignete Wahl des mindestens einen Schwellenwerts. Sie sind außerdem einer einfachen Messung zugänglich. Die übrigen Aufstellungsparameter beeinflussen direkt die Impedanz oder den elektrischen Widerstand des Bodens oder eines Übergangs zwischen der Energiebereitstellungsvorrichtung, konkret der mindestens einen Erdungs-Standfläche, und dem Boden. Insbesondere beeinflusst die Bodenebenheit die tatsächlich vorliegende, berührende Kontaktfläche zwischen der mindestens eine Erdungs-Standfläche und dem Boden und damit direkt den Übergangswiderstand. Der mindestens eine Aufstellungsparameter kann beispielsweise durch eine Person, welche die Energiebereitstellungsvorrichtung an dem Aufstellort aufstellt, eingegeben und zur Bestimmung des mindestens einen Schwellenwerts in der Berührsicherheits-Überwachungsvorrichtung verwendet werden, oder er kann aus einer Datenbank oder Cloud, vorzugsweise online, besonders bevorzugt in Echtzeit, heruntergeladen werden. Alternativ oder zusätzlich ist es möglich, dass der mindestens eine Aufstellungsparameter durch die Energiebereitstellungsvorrichtung, insbesondere die Messvorrichtung, bestimmt wird.

In einer Ausführungsform der Energiebereitstellungsvorrichtung ist die Berührsicherheits-Überwachungsvorrichtung eingerichtet, um den mindestens einen Schwellenwert zeitlich in Abhängigkeit von dem wenigstens einen Aufstellungsparameter zu variieren, vorzugsweise kontinuierlich, oder in vorbestimmten Zeitabständen, oder ereignisgesteuert, beispielsweise durch einsetzenden Regen oder aufgrund einer Trockenperiode, die eine vorbestimmte Zeitdauer überschreitet.

Vorzugsweise wird ein als Grenz-Stromstärke ausgestalteter Schwellenwert in Abhängigkeit von dem mindestens einen Aufstellungsparameter variiert. Ein als Grenz-Spannung ausgestalteter Schwellenwert wird demgegenüber bevorzugt - unabhängig von dem mindestens einen Aufstellungsparameter - konstant gehalten. Insbesondere ist ein Spannungsgrenzwert für die Berührspannung normativ festgelegt, während eine noch tolerierbare Stromstärke von den konkret vorliegenden Bedingungen und insbesondere dem mindestens einen Aufstellungsparameter abhängt.

Gemäß einer Weiterbildung der Erfindung ist vorgesehen, dass die Messvorrichtung eingerichtet ist, um die mindestens eine elektrische Messgröße zeitabhängig zu erfassen, insbesondere als Signal, insbesondere als zeitvariables Signal, insbesondere als eine Kombination aus einem AC-Signal und einem DC-Signal (gemischtes AC- und DC-Signal), oder als AC-Signal, oder als zeitlich variierendes DC-Signal. Die Berührsicherheits-Überwachungsvorrichtung ist eingerichtet, um die Berührsicherheit anhand der zeitabhängig erfassten mindestens einen elektrischen Messgröße zu bewerten. Auf diese Weise kann die Berührsicherheit vorteilhaft besonders exakt bewertet werden, wobei es auch möglich ist, eine zeitabhängige Veränderung der Berührsicherheit festzustellen. Vorzugsweise ist die Berührsicherheits-Überwachungsvorrichtung eingerichtet, um die zeitabhängig erfasste elektrische Messgröße auszuwerten, insbesondere einer Signalauswertung durchzuführen, und um die Berührsicherheit anhand der ausgewerteten elektrischen Messgröße, insbesondere anhand der Signalauswertung, zu bewerten. Beispielsweise ist es möglich, dass die zeitabhängig erfasste elektrische Messgröße einer Filterung, insbesondere einer Tiefpassfilterung, unterworfen wird, um die Bewertung der Berührsicherheit unempfindlich gegenüber kurzfristigen Schwankungen der elektrischen Messgröße zu machen.

In einer Ausführungsform der Energiebereitstellungsvorrichtung weist die Berührsicherheits-Überwachungsvorrichtung zusätzlich zu der Messvorrichtung eine mit der Messvorrichtung - insbesondere datenübertragend oder signalübertragend - wirkverbundene Rechenvorrichtung auf, die eingerichtet ist, um die Berührsicherheit in Abhängigkeit von der durch die Messvorrichtung erfassten mindestens einen elektrischen Messgröße zu bewerten, insbesondere den Vergleich mit dem mindestens einen Schwellenwert durchzuführen und/oder die Bewertung der Berührsicherheit anhand der zeitabhängig erfassten mindestens einen elektrischen Messgröße, insbesondere mittels Signalauswertung, durchzuführen. Die Rechenvorrichtung kann dabei insbesondere auch eine im Übrigen für den Betrieb der Energiebereitstellungsvorrichtung vorgesehene Steuervorrichtung sein.

Gemäß einer Weiterbildung der Erfindung ist vorgesehen, dass die Berührsicherheits-Überwachungsvorrichtung als die mindestens eine Kontaktplatte zwei, insbesondere genau zwei, Kontaktplatten aufweist, die voneinander - und insbesondere von der mindestens einen Erdungs-Standfläche - beabstandet angeordnet und eingerichtet sind, um an dem Aufstellort in berührendem Kontakt mit dem Boden zu sein.

In einer Ausführungsform weist jede Kontaktplatte der genau zwei Kontaktplatten eine Fläche von ca. 200 cm², insbesondere von 190 cm² bis 210 cm², vorzugsweise 200 cm², auf, sodass die beiden Kontaktplatten insgesamt eine Fläche von ca. 400 cm², insbesondere von 380 cm² bis 420 cm², vorzugsweise 400 cm², aufweisen.

Insbesondere mit einer Fläche von jeweils 200 cm², einer Gesamtfläche von 400 cm², und einer Kraft von jeweils 250 N, insgesamt also 500 N, mit der die beiden Kontaktplatten gegen den Boden gedrängt werden, bilden die Kontaktplatten menschliche Füße eines Benutzers der Energiebereitstellungsvorrichtung an dem Aufstellort nach, sodass die Berührsicherheit eines Benutzers mittels der Berührsicherheits-Überwachungsvorrichtung an dem Aufstellort unter realistischen Bedingungen überwacht werden kann.

In einer Ausführungsform der Energiebereitstellungsvorrichtung sind die beiden Kontaktplatten elektrisch parallel zueinander mit der Messvorrichtung verbunden. Auch insoweit stimmt die Ausgestaltung der Kontaktplatten mit den Eigenschaften menschlicher Füße überein.

Gemäß einer Weiterbildung der Erfindung ist vorgesehen, dass die Messvorrichtung mit den beiden Kontaktplatten wirkverbunden, das heißt insbesondere elektrisch verbunden, und eingerichtet ist, um eine Impedanz zwischen den Kontaktplatten zu messen. Insbesondere über die Impedanz zwischen den Kontaktplatten ist es möglich, Informationen über den wenigstens einen Aufstellungsparameter zu erhalten und daraus mindestens einen geeigneten Schwellenwert abzuleiten, sodass die Berührsicherheit - insbesondere zu jeder Zeit - gewährleistet ist.

In einer Ausführungsform der Energiebereitstellungsvorrichtung ist die Messvorrichtung eingerichtet, um die Impedanz zwischen den Kontaktplatten passiv zu messen. In einer anderen Ausführungsform der Energiebereitstellungsvorrichtung ist die Messvorrichtung eingerichtet, um die Impedanz zwischen den Kontaktplatten aktiv zu messen, insbesondere durch Aufprägen eines Signals, insbesondere eines Wechselstromsignals (AC-Signal).

In einer Ausführungsform der Energiebereitstellungsvorrichtung ist die Messvorrichtung eingerichtet, um die Impedanz zwischen den Kontaktplatten als Gleichstrom-Widerstand oder ohmscher Widerstand zu messen. In einer anderen Ausführungsform der Energiebereitstellungsvorrichtung ist die Messvorrichtung eingerichtet, um die Impedanz zwischen den Kontaktplatten als Wechselstrom-Widerstand, das heißt als Impedanz im engeren Sinn, zu messen.

Gemäß einer Weiterbildung der Erfindung ist vorgesehen, dass die Energiebereitstellungsvorrichtung als eine Vorrichtung ausgebildet ist, die ausgewählt ist aus einer Gruppe, bestehend aus einem elektrischen Energiespeicher, einer Ladesäule, insbesondere zum Laden elektrisch angetriebener Kraftfahrzeuge, und einem elektronischen Leistungswandler. Der elektronische Leistungswandler kann dabei insbesondere ein Wechselrichter, Gleichrichter, Hochsetzsteller, oder Tiefsetzsteller sein. Insbesondere kann der elektronische Leistungswandler eingerichtet sein zur Verwendung mit einer Photovoltaikvorrichtung, die vorteilhafterweise insbesondere am selben Aufstellort wie die Energiebereitstellungsvorrichtung angeordnet oder sogar mechanisch mit der Energiebereitstellungsvorrichtung verbunden, beispielsweise auf einem Dachbereich der Energiebereitstellungsvorrichtung angeordnet sein kann, insbesondere um lokal Energie zu ernten und bereitzustellen. Neben den eingangs beschriebenen Anwendungen kann die Energiebereitstellungsvorrichtung insbesondere auch eingerichtet sein, um beispielsweise Energie auf einer Baustelle, insbesondere für Baumaschinen, bereitzustellen. Selbstverständlich kann die Energiebereitstellungsvorrichtung auch für andere Anwendungen verwendet werden oder spezifisch eingerichtet sein.

Gemäß einer Weiterbildung der Erfindung ist vorgesehen, dass der Energieversorgungsanschluss ein Ladekabel aufweist, das einen Schutzleiter umfasst, wobei die Berührsicherheits-Überwachungsvorrichtung, insbesondere die Messvorrichtung, mit dem Schutzleiter elektrisch verbunden ist. Insbesondere in einem solchen Fall ist die Berührsicherheits-Überwachungsvorrichtung auch eingerichtet, um eine Berührstelle außerhalb der Energiebereitstellungsvorrichtung, beispielsweise an einer mit dieser elektrisch verbundenen Vorrichtung, beispielsweise einem elektrischen Kraftfahrzeug, zu überwachen.

In einer Ausführungsform weist die Energiebereitstellungsvorrichtung eine Mehrzahl von Energieversorgungsanschlüssen, insbesondere eine Mehrzahl von Ladekabeln auf. Es ist dann vorteilhaft möglich, eine Mehrzahl von anderen elektrischen Vorrichtungen, insbesondere Kraftfahrzeugen, gleichzeitig mit der Energiebereitstellungsvorrichtung zu verbinden.

Gemäß einer Weiterbildung der Erfindung ist vorgesehen, dass die Messvorrichtung einen gemeinsamen Kontaktpunkt sowie eine Messschaltung aufweist. Eine erste Kontaktplatte der beiden Kontaktplatten ist über einen ersten Verbindungsleiter mit dem gemeinsamen Kontaktpunkt elektrisch verbunden. Eine zweite Kontaktplatte der beiden Kontaktplatten ist über einen zweiten Verbindungsleiter mit dem gemeinsamen Kontaktpunkt elektrisch verbunden. Die Messschaltung ist mit der mindestens einen Berührstelle und mit dem gemeinsamen Kontaktpunkt elektrisch verbunden und eingerichtet, um die mindestens eine elektrische Messgröße zwischen der mindestens einen Berührstelle und dem gemeinsamen Kontaktpunkt zu messen. Insbesondere weist die Messschaltung einen ersten, mit einer ersten Kontaktplatte der beiden Kontaktplatten elektrisch verbundenen Anschluss, einen zweiten, mit einer zweiten Kontaktplatte der beiden Kontaktplatten elektrisch verbundenen Anschluss und einen dritten, mit der mindestens einen Berührstelle elektrisch verbundenen Anschluss auf. Der erste Anschluss und der zweite Anschluss sind elektrisch in dem gemeinsamen Kontaktpunkt miteinander verbunden, und die Messschaltung ist eingerichtet, um die mindestens eine elektrische Messgröße zwischen dem dritten Anschluss und dem gemeinsamen Kontaktpunkt zu messen. Der gemeinsame Kontaktpunkt muss dabei nicht als räumlich-geometrisch identifizierbarer Punkt ausgebildet sein. Vielmehr genügt es, wenn der erste Anschluss und der zweite Anschluss, oder der erste Verbindungsleiter und der zweite Verbindungsleiter, elektrisch miteinander verbunden sind, wobei die Messschaltung eingerichtet ist, um die mindestens eine elektrische Messgröße zwischen der Berührstelle einerseits und irgendeiner Stelle in der elektrischen Verbindung zwischen dem ersten Anschluss und dem zweiten Anschluss, oder dem ersten Verbindungsleiter und dem zweiten Verbindungsleiter, zu messen. Der gemeinsamen Kontaktpunkt kann also insbesondere als gedachter gemeinsamer Kontaktpunkt ausgebildet sein. Selbstverständlich ist es aber auch möglich, dass der gemeinsame Kontaktpunkt auch räumlich-geometrisch identifizierbar existiert, beispielsweise als Lötstelle oder dergleichen.

Gemäß einer Weiterbildung der Erfindung ist vorgesehen, dass die Messvorrichtung eingerichtet ist, um die Impedanz zwischen den beiden Kontaktplatten, insbesondere zwischen dem ersten Verbindungsleiter und dem zweiten Verbindungsleiter, oder entsprechend zwischen dem ersten Anschluss und dem zweiten Anschluss, zu messen. In dem ersten Verbindungsleiter ist eine erste Entkopplungsvorrichtung angeordnet. In dem zweiten Verbindungsleiter ist eine zweite Entkopplungsvorrichtung angeordnet. Mittels der Entkopplungsvorrichtung kann vorteilhaft eine elektrische Trennung gewährleistet werden, sodass nicht etwa lediglich oder im Wesentlichen die Impedanz der Messschaltung, sondern tatsächlich die Impedanz zwischen den Kontaktplatten gemessen und damit eine sinnvolle Information über den wenigstens einen Aufstellungsparameter erhalten wird.

Gemäß einer Weiterbildung der Erfindung ist vorgesehen, dass zumindest eine Entkopplungsvorrichtung, ausgewählt aus der ersten Entkopplungsvorrichtung und der zweiten Entkopplungsvorrichtung, als Entkoppelwiderstand ausgebildet ist. Dies stellt eine besonders einfache und robuste Ausgestaltung der Entkopplungsvorrichtung dar. Ist der jeweilige Entkoppelwiderstand bekannt, kann er auf einfache Weise bei der Ermittlung der Impedanz zwischen den Kontaktplatten berücksichtigt werden.

In einer Ausführungsform der Energiebereitstellungsvorrichtung ist zumindest einer der Entkoppelwiderstände, vorzugsweise jeweils der erste Entkoppelwiderstand und der zweite Entkoppelwiderstand, als ohmscher Widerstand ausgebildet. Der erste Entkoppelwiderstand und/oder der zweite Entkoppelwiderstand weisen bevorzugt jeweils einen Widerstandswert von 500 Ω bis 1 kΩ auf. Vorzugsweise weisen der erste Entkoppelwiderstand und der zweite Entkoppelwiderstand denselben Widerstandswert auf.

In einer anderen Ausführungsform der Energiebereitstellungsvorrichtung ist zumindest einer der Entkoppelwiderstände, vorzugsweise jeweils der erste Entkoppelwiderstand und der zweite Entkoppelwiderstand, als Spule, insbesondere Drossel, ausgebildet.

In einer Ausführungsform der Energiebereitstellungsvorrichtung sind sowohl die erste Entkopplungsvorrichtung als auch die zweite Entkopplungsvorrichtung jeweils als Entkoppelwiderstand ausgebildet.

In einer alternativen Ausführungsform der Erfindung ist vorgesehen, dass zumindest eine Entkopplungsvorrichtung, ausgewählt aus der ersten Entkopplungsvorrichtung und der zweiten Entkopplungsvorrichtung, als Schalter, insbesondere als ansteuerbarer Schalter, ausgebildet ist. Dies stellt eine Möglichkeit dar, die Impedanz mit besonders hoher Genauigkeit und zugleich flexibel, insbesondere mit einer Möglichkeit zur Plausibilisierung, zu ermitteln.

In einer Ausführungsform der Energiebereitstellungsvorrichtung sind sowohl die erste Entkopplungsvorrichtung als auch die zweite Entkopplungsvorrichtung jeweils als Schalter, insbesondere als ansteuerbarer Schalter, ausgebildet. Insbesondere ist die erste Entkopplungsvorrichtung als ein erster ansteuerbarer Schalter ausgebildet, und die zweite Entkopplungsvorrichtung ist ein zweiter ansteuerbarer Schalter ausgebildet. Durch wechselweise Ansteuerung des ersten Schalters und des zweiten Schalters, sodass in einem ersten Funktionszustand der erste Schalter geschlossen und der zweite Schalter geöffnet ist, wobei in einem zweiten Funktionszustand der erste Schalter geöffnet und der zweite Schalter geschlossen ist, kann für jeden Verbindungsleiter einzeln, das heißt insbesondere für jede Kontaktplatte einzeln, eine Schleifenimpedanz über den Boden, die mindestens eine Erdungs-Standfläche, und die Messvorrichtung ermittelt werden, wobei vorzugsweise eine innere Impedanz oder Innenwiderstand der Messschaltung bekannt ist, sodass im Ergebnis relevante Informationen über den wenigstens einen Aufstellungsparameter erhalten werden. Dabei können die beiden für die Kontaktplatten separat durchgeführten Messungen gegeneinander plausibilisiert werden. In einem dritten Funktionszustand sind bevorzugt beide Schalter geöffnet, es kann dann unmittelbar die Impedanz zwischen den Kontaktplatten ermittelt werden. Aus einer Kombination der Messungen in dem ersten Funktionszustand, dem zweiten Funktionszustand und dem dritten Funktionszustand kann schließlich auch der Erdungswiderstand im Bereich der mindestens einen Erdungs-Standfläche erhalten werden. Insgesamt können mit dieser Schaltung somit mehrere parasitäre Komponenten mit höchster Präzision erfasst werden. Zu dem Zweck der Überwachung der Berührsicherheit im engeren Sinn, d.h. insbesondere zur Messung der mindestens einen elektrischen Messgröße zwischen der mindestens einen Berührstelle und der mindestens einen Kontaktplatte, sind bevorzugt in einem vierten Funktionszustand beide Schalter geschlossen.

In einer Ausführungsform der Energiebereitstellungsvorrichtung ist mindestens einer der Schalter als Halbleiterschalter ausgebildet. Vorzugsweise sind beide Schalter als Halbleiterschalter ausgebildet.

Gemäß einer Weiterbildung der Erfindung ist vorgesehen, dass ein erster Messwiderstand in die Messschaltung integriert ist. Der Messwiderstand erlaubt vorteilhaft eine einfache Messung der Berührspannung, insbesondere als über dem Messwiderstand abfallende Spannung, sowie gegebenenfalls des Berührstroms, insbesondere als durch den Messwiderstand fließende Stromstärke. Der Messwiderstand weist bevorzugt einen Widerstandswert von 0,5 kΩ bis 1,5 kΩ auf.

In einer alternativen Ausführungsform der Erfindung ist vorgesehen, dass die erste Kontaktplatte elektrisch parallel zu dem ersten Verbindungsleiter und der Messschaltung über einen zweiten Messwiderstand mit der mindestens einen Berührstelle verbunden ist, wobei die zweite Kontaktplatte elektrisch parallel zu dem zweiten Verbindungsleiter und der Messschaltung über einen dritten Messwiderstand mit der mindestens einen Berührstelle verbunden ist. In diesem Fall wird die Entkopplung der Impedanzmessung vorteilhaft durch die Messwiderstände selbst bewirkt. Sind zwei zueinander parallelgeschaltete Messwiderstände anstelle eines Messwiderstands vorgesehen, weist bevorzugt jeder Messwiderstand der beiden Messwiderstände im Vergleich zu dem nur einen Messwiderstand einen doppelten Widerstandswert auf.

In einer Ausführungsform der Energiebereitstellungsvorrichtung ist zumindest einer der Messwiderstände, vorzugsweise jeweils der erste Messwiderstand und der zweite Messwiderstand, als ohmscher Widerstand ausgebildet.

In einer anderen Ausführungsform der Energiebereitstellungsvorrichtung ist zumindest einer der Messwiderstände, vorzugsweise jeweils der erste Messwiderstand und der zweite Messwiderstand, als Spule, insbesondere Drossel, ausgebildet.

Gemäß einer Weiterbildung der Erfindung ist vorgesehen, dass eine erste Kontaktplatte der beiden Kontaktplatten über einen ersten Messleiter elektrisch mit der mindestens einen Berührstelle verbunden ist. Eine zweite Kontaktplatte der beiden Kontaktplatten ist über einen zweiten Messleiter elektrisch mit der mindestens einen Berührstelle verbunden. In dem ersten Messleiter ist ein vierter Messwiderstand angeordnet. In dem zweiten Messleiter ist ein fünfter Messwiderstand angeordnet. Die Messvorrichtung ist eingerichtet, um eine erste, über dem vierten Messwiderstand abfallende elektrische Spannung zu messen, und um eine zweite, über dem fünften Messwiderstand abfallende elektrische Spannung zu messen. Die beiden separaten Spannungsmessungen können vorteilhaft zur Plausibilisierung verwendet werden.

Die Erfindung wird im Folgenden anhand der Zeichnung näher erläutert. Dabei zeigen:
- Figur 1: eine schematische Darstellung eines Ausführungsbeispiels einer mobilen elektrischen Energiebereitstellungsvorrichtung;
- Figur 2: eine schematische Darstellung eines ersten Ausführungsbeispiels einer Messvorrichtung der Energiebereitstellungsvorrichtung;
- Figur 3: eine schematische Darstellung eines zweiten Ausführungsbeispiels einer Messvorrichtung der Energiebereitstellungsvorrichtung;
- Figur 4: eine schematische Darstellung eines dritten Ausführungsbeispiels einer Messvorrichtung der Energiebereitstellungsvorrichtung, und
- Figur 5: eine schematische Darstellung eines vierten Ausführungsbeispiels einer Messvorrichtung der Energiebereitstellungsvorrichtung.

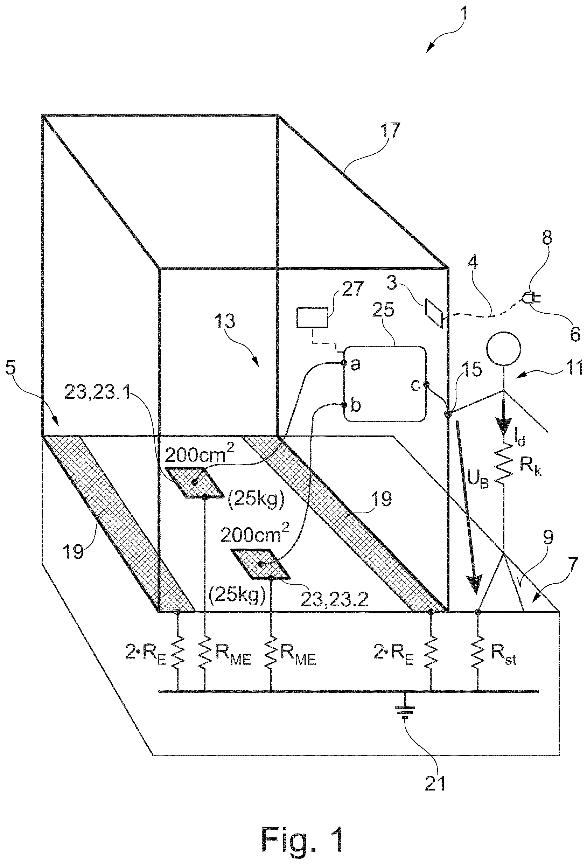

**Fig.** 1 zeigt eine schematische Darstellung eines Ausführungsbeispiels einer mobilen elektrischen Energiebereitstellungsvorrichtung 1. Diese weist mindestens einen hier nur schematisch angedeuteten Energieversorgungsanschluss 3 zur Entnahme von Energie aus der Energiebereitstellungsvorrichtung 1 auf. Der Energieversorgungsanschluss 3 kann als Anschlussdose oder als Ladekabel 4, insbesondere verbunden mit einem Stecker 6, ausgebildet sein. Es ist möglich, dass die Energiebereitstellungsvorrichtung 1 eine Mehrzahl von Energieversorgungsanschlüssen 3 aufweist, beispielsweise um eine Mehrzahl von elektrischen Kraftfahrzeugen zugleich laden zu können. Die Energiebereitstellungsvorrichtung 1 weist eine Bodenerdungsvorrichtung 5 auf, die eingerichtet ist, um an einem Aufstellort 7 der Energiebereitstellungsvorrichtung 1 mit einem Boden 9 des Aufstellorts 7 zusammenzuwirken, um eine Erdung für die Energieversorgungsvorrichtung 1 bereitzustellen. Zur Gewährleistung der elektrischen Berührsicherheit für einen Benutzer 11 weist die Energiebereitstellungsvorrichtung 1 eine Berührsicherheits-Überwachungsvorrichtung 13 auf, die eingerichtet ist, um mindestens eine an der Energiebereitstellungsvorrichtung 1 angeordnete oder mit der Energiebereitstellungsvorrichtung 1 elektrisch verbundene Berührstelle 15 auf Berührsicherheit zu überwachen. Dadurch ist es vorteilhaft für den Benutzer 11 gefahrlos möglich, die Energiebereitstellungsvorrichtung 1 auch an einem Aufstellort 7 zu betreiben, wo keine Möglichkeit einer Verbindung mit einer Haupterdungsschiene, einem Fundamenterder, einem Tiefenerder oder dergleichen besteht.

Die Berührstelle 15 ist in dem hier dargestellten Fall an einem Gehäuse 17 der Energiebereitstellungsvorrichtung 1 angeordnet. Zusätzlich oder alternativ ist es möglich, dass die Berührstelle 15 an einer anderen, zu der Energiebereitstellungsvorrichtung 1 externen, aber mit der Energiebereitstellungsvorrichtung 1 elektrisch verbundenen Vorrichtung, beispielsweise einem elektrischen Kraftfahrzeug, angeordnet ist. Insbesondere ist es möglich, dass ein Ladekabel des Energieversorgungsanschlusses 3 einen Schutzleiter 8 aufweist, wobei dann die Berührsicherheits-Überwachungsvorrichtung 13 mit dem Schutzleiter 8 elektrisch verbunden ist.

Die Energiebereitstellungsvorrichtung 1 weist in hier nicht explizit dargestellter Weise mindestens eine elektrische oder elektronische Vorrichtung zur Bereitstellung elektrischer Energie auf, die mit dem Energieversorgungsanschluss 3 elektrisch verbunden und vorzugsweise in dem Gehäuse 17 angeordnet ist. Die elektrische oder elektronische Vorrichtung kann insbesondere als Batterie und/oder als Leistungswandler-Schaltung ausgebildet sein. Die Energiebereitstellungsvorrichtung 1 ist bevorzugt als eine Vorrichtung ausgebildet, die ausgewählt ist aus einer Gruppe, bestehend aus: Einem elektrischen Energiespeicher, einer Ladesäule, insbesondere zum Laden elektrisch angetriebener Kraftfahrzeuge, und einem elektronischen Leistungswandler, insbesondere einem Wechselrichter, einem Gleichrichter, einem Hochsetzsteller, oder einem Tiefsetzsteller.

Die Bodenerdungsvorrichtung 5 weist bevorzugt mindestens eine Erdungs-Standfläche 19, hier insbesondere zwei voneinander beabstandete Erdungs-Standflächen 19, auf, wobei die mindestens eine Erdungs-Standfläche 19 angeordnet und eingerichtet ist, um an dem Aufstellort 7 in berührendem Kontakt mit dem Boden 9 zu sein. Schematisch dargestellt ist, dass die Erdungs-Standflächen 19 zu einem gedachten Erdungspunkt 21 jeweils einen Teil-Erdungswiderstand aufweisen, der hier mit 2*R_{E}* angegeben ist, sodass sich ein Gesamt-Erdungswiderstand für die Energiebereitstellungsvorrichtung 1 aufgrund der elektrischen Parallelschaltung der beiden Teil-Erdungswiderstände der Erdungs-Standflächen 19 zu *R_{E}* ergibt. Die einzelnen Teil-Erdungswiderstände 2*R_{E}* und damit auch der Gesamt-Erdungswiderstand *R_{E}* hängen von den konkreten Aufstellbedingungen der elektrischen Energiebereitstellungsvorrichtung 1 an dem Aufstellort 7, insbesondere von mindestens einem Aufstellungsparameter ab, insbesondere von einer Impedanz oder einem elektrischen Widerstand des Bodens an dem Aufstellungsort, einer chemischen Zusammensetzung des Bodens, einer physikalischen Beschaffenheit des Bodens, einer Feuchte oder einem Wassergehalt des Bodens, und einer Bodenebenheit an dem Aufstellort.

Die Berührsicherheits-Überwachungsvorrichtung 13 weist mindestens eine Kontaktplatte 23, hier zwei voneinander beabstandet angeordnete Kontaktplatten 23, nämlich eine erste Kontaktplatte 23.1 und eine zweite Kontaktplatte 23.2, auf. Die Kontaktplatten 23 sind angeordnet und eingerichtet, um an dem Aufstellort 7 in berührendem Kontakt mit dem Boden 9 zu sein. Jede Kontaktplatte 23 der Kontaktplatten 23 weist bevorzugt eine Fläche von 200 cm² und eine Masse von 25 kg auf, sodass sich insgesamt eine summierte Gesamt-Kontaktfläche von 400 cm² und eine Gesamt-Aufstandskraft von 500 N auf dem Boden 9 für die Kontaktplatten 23 der Berührsicherheits-Überwachungsvorrichtung 13 ergibt. Insbesondere auf diese Weise bilden die Kontaktplatten 23 den Kontakt der Füße des menschlichen Benutzers 11 mit dem Boden 9 nach. Die Kontaktplatten 23 weisen zu dem gedachten Erdungspunkt 21 jeweils einen mit *R_{ME}* bezeichneten Kontaktwiderstand auf. Die Kontaktwiderstände der Kontaktplatten 23 sind hier insbesondere der einfacheren Darstellung wegen als gleich angegeben. Dabei können sie durchaus - nicht zuletzt insbesondere abhängig von den konkreten Aufstellbedingungen - gleich sein, es ist aber auch möglich, dass die Kontaktwiderstände der Kontaktplatten 23 voneinander verschieden sind.

Die Berührsicherheits-Überwachungsvorrichtung 13 weist außerdem eine Messvorrichtung 25 auf, die einerseits mit den Kontaktplatten 23 und andererseits mit der Berührstelle 15 wirkverbunden, das heißt insbesondere elektrisch verbunden ist. Die Kontaktplatten 23 sind insbesondere elektrisch parallel zueinander mit der Messvorrichtung 25 verbunden. Die Messvorrichtung 25 ist eingerichtet, um die Berührsicherheit an der Berührstelle 15 durch Messen und vorzugsweise Auswerten mindestens einer elektrischen Messgröße zu überwachen.

Insbesondere ist die Messvorrichtung 25 eingerichtet, um die mindestens eine elektrische Messgröße zwischen der Berührstelle 15 und den Kontaktplatten 23 zu messen. Die mindestens eine elektrische Messgröße ist dabei ausgewählt aus einer Gruppe, bestehend aus: Einer Spannung und einer Stromstärke.

Die Berührsicherheit des Benutzers 11 ist zum einen bestimmt durch eine Berührspannung *U_{B}*, die über dem Körper des Benutzers 11, hier dargestellt durch einen Körper-Widerstand Rk, zwischen der Berührstelle 15 und dem Boden 9 abfällt, und andererseits durch eine Berührstromstärke *I_{d}*, die durch den Körper, das heißt im Ersatzschaltbild den Körperwiderstand *Rₖ* und einen Standort-Widerstand *Rₛₜ*, fließt. Die Füße des Benutzers 11 sind dabei mit dem gedachten Erdungspunkt 21 über den Standort-Widerstand *Rₛₜ* elektrisch verbunden.

Die Berührspannung *U_{B}* soll vorzugsweise kleiner als eine Grenz-Spannung von 50 V als Schwellenwert sein. Die Berührstromstärke *I_{d}* soll vorzugsweise kleiner als eine Grenz-Stromstärke von 30 mA als Schwellenwert sein. Insbesondere wenn beide Bedingungen erfüllt sind, ist die Berührsicherheit gegeben. Die Schwellenwerte können insbesondere auch geringer gewählt werden.

Mittels der Berührsicherheits-Überwachungsvorrichtung 13 werden die elektrischen Gegebenheiten für den Benutzer 11 quasi nachgebildet, und es wird insbesondere versucht, zumindest einen Berührsicherheits-Parameter, ausgewählt aus der Berührspannung *U_{B}* und der Berührstromstärke *I_{d}*, vorzugsweise beide Berührsicherheits-Parameter, anhand einer geeigneten Messung abzuschätzen.

Die Berührsicherheits-Überwachungsvorrichtung 13, insbesondere die Messvorrichtung 25, ist bevorzugt eingerichtet, um einen Messwert der mindestens einen elektrischen Messgröße mit einem Schwellenwert, insbesondere den oben angegebenen oder daraus abgeleiteten Schwellenwerten, zu vergleichen, und um die Berührsicherheit anhand des Vergleichs zu bewerten. Der Schwellenwert kann dabei insbesondere fix vorgegeben oder aber, insbesondere abhängig von dem wenigstens einen Aufstellungsparameter, variabel sein.

Bevorzugt ist die Messvorrichtung 25 eingerichtet, um die mindestens eine elektrische Messgröße zeitabhängig zu erfassen, insbesondere als Signal. Die Berührsicherheits-Überwachungsvorrichtung 13, insbesondere die Messvorrichtung 25, ist bevorzugt eingerichtet, um die Berührsicherheit anhand der zeitabhängig erfassten mindestens einen elektrischen Messgröße, insbesondere mittels Signalauswertung, zu bewerten.

In einer bevorzugten Ausgestaltung weist die Berührsicherheits-Überwachungsvorrichtung 13 zusätzlich zu der Messvorrichtung 25 eine mit der Messvorrichtung 25 wirkverbundene Rechenvorrichtung 27 auf, die eingerichtet ist, um die Berührsicherheit in Abhängigkeit von der durch die Messvorrichtung 25 erfassten mindestens einen elektrischen Messgröße zu bewerten, insbesondere den Vergleich mit dem Schwellenwert durchzuführen und/oder die Bewertung der Berührsicherheit anhand der zeitabhängig erfassten mindestens einen elektrischen Messgröße, insbesondere mittels Signalauswertung, durchzuführen.

Die Messvorrichtung 25 ist bevorzugt eingerichtet, um eine Impedanz zwischen den beiden Kontaktplatten 23 zu messen, insbesondere um daraus eine Information über den mindestens einen Aufstellungsparameter und damit zumindest mittelbar über die Kontaktwiderstände *R_{ME}*, den Gesamt-Erdungswiderstand *R_{E}*, und damit letztlich auch den Standort-Widerstand *Rₛₜ* zu erhalten.

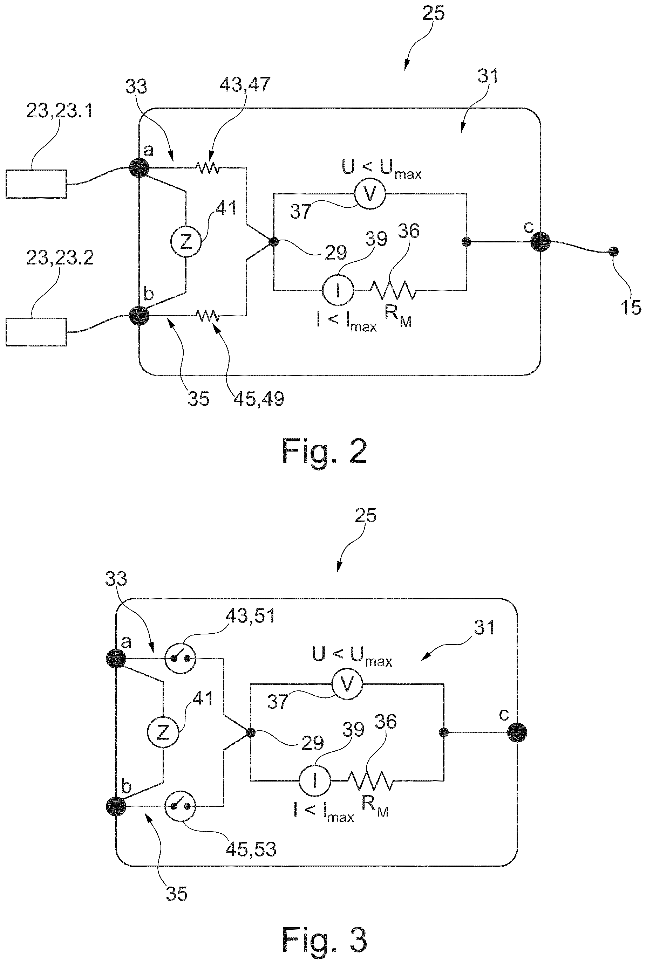

Fig. 2 zeigt eine schematische Darstellung eines ersten Ausführungsbeispiels der Messvorrichtung 25 der Energiebereitstellungsvorrichtung 1.

Gleiche und funktionsgleiche Elemente sind in allen Figuren mit gleichen Bezugszeichen versehen, sodass insofern jeweils auf die vorangegangene Beschreibung verwiesen wird.

Die Messvorrichtung 25 weist einen gemeinsamen Kontaktpunkt 29 sowie eine Messschaltung 31 auf. Die erste Kontaktplatte 23.1 ist über einen ersten Verbindungsleiter 33 mit dem gemeinsamen Kontaktpunkt 29 elektrisch verbunden. Die zweite Kontaktplatte 23.2 ist über einen zweiten Verbindungsleiter 35 mit dem gemeinsamen Kontaktpunkt 29 elektrisch verbunden. Die Messschaltung 31 ist mit der mindestens einen Berührstelle 15 und mit dem gemeinsamen Kontaktpunkt 29 elektrisch verbunden und eingerichtet, um die mindestens eine elektrische Messgröße zwischen der Berührstelle 15 und dem gemeinsamen Kontaktpunkt 29 zu messen. Insbesondere weist die Messvorrichtung 25 einen ersten, mit der ersten Kontaktplatte 23.1 elektrisch verbundenen Anschluss a, einen zweiten, mit der zweiten Kontaktplatte 23.2 elektrisch verbundenen Anschluss b, und einen dritten, mit der Berührstelle 15 elektrisch verbundenen Anschluss c auf, wobei die Messschaltung 31 eingerichtet ist, um die mindestens eine elektrische Messgröße zwischen dem dritten Anschluss c und dem gemeinsamen Kontaktpunkt 29 zu messen.

Insbesondere weist die Messschaltung 31 einen Messwiderstand 36 mit dem Widerstandswert *R_{M}* und eine Spannungsmessvorrichtung 37, insbesondere ein Voltmeter, auf, die angeordnet und eingerichtet ist, um eine über dem Messwiderstand 36 abfallende Spannung U zu messen. Bevorzugt weist die Messschaltung 31 außerdem eine Strommessvorrichtung 39, insbesondere ein Amperemeter, auf, die angeordnet und eingerichtet ist, um eine durch den Messwiderstand 36 fließende Stromstärke I zu messen. Die Messvorrichtung 25 oder die Rechenvorrichtung 27 ist bevorzugt eingerichtet, um die Spannung *U* mit einer Grenz-Spannung *Uₘₐₓ* zu vergleichen, und/oder um die Stromstärke I mit einer Grenz-Stromstärke *Iₘₐₓ* zu vergleichen, und um die Berührsicherheit anhand des Vergleichs zu bewerten.

Die Messvorrichtung 25 ist außerdem bevorzugt eingerichtet, um eine Impedanz Z zwischen den Kontaktplatten 23, insbesondere zwischen dem ersten Verbindungsleiter 33 und dem zweiten Verbindungsleiter 35, zu messen. Hierzu weist die Messvorrichtung 25 vorzugsweise eine Impedanz-Messvorrichtung 41 auf, die angeordnet und eingerichtet ist, um die Impedanz Z zu messen.

Vorzugsweise ist in dem ersten Verbindungsleiter 33 eine erste Entkopplungsvorrichtung 43 angeordnet, und in dem zweiten Verbindungsleiter 35 ist eine zweite Entkopplungsvorrichtung 45 angeordnet. Die Entkopplungsvorrichtungen 43, 45 gewährleisten in vorteilhafter Weise, dass mittels der Impedanz-Messvorrichtung 41 tatsächlich die Impedanz Z zwischen den Kontaktplatten 23 und nicht etwa ein Kurzschluss oder eine innere Impedanz der Messschaltung 31 gemessen wird.

Bei dem ersten Ausführungsbeispiel der Messvorrichtung 25 gemäß Figur 2 sind die Entkopplungsvorrichtungen 43, 45 jeweils als Entkopplungswiderstände 47, 49 ausgebildet.

Fig. 3 zeigt eine schematische Darstellung eines zweiten Ausführungsbeispiels der Messvorrichtung 25. Bei diesem zweiten Ausführungsbeispiel sind die Entkopplungsvorrichtungen 43, 45 jeweils als insbesondere ansteuerbare Schalter 51, 53 ausgebildet. Insbesondere ist die erste Entkopplungsvorrichtung 43 als ein erster ansteuerbarer Schalter 51 ausgebildet, und die zweite Entkopplungsvorrichtung 45 ist ein zweiter ansteuerbarer Schalter 53 ausgebildet. Vorzugsweise werden der erste Schalter 51 und der zweite Schalter 53 wechselweise angesteuert, insbesondere durch die Rechenvorrichtung 27. In einem ersten Funktionszustand ist der erste Schalter 51 geschlossen, und der zweite Schalter 53 ist geöffnet. In einem zweiten Funktionszustand ist der erste Schalter 51 geöffnet, und der zweite Schalter 53 ist geschlossen. Auf diese Weise kann für jede Kontaktplatte 23 einzeln eine Schleifenimpedanz über den Boden 9, die Erdungs-Standflächen 19, und die Messschaltung 31 ermittelt werden, wobei vorzugsweise eine innere Impedanz oder ein Innenwiderstand der Messschaltung 31 bekannt ist, sodass letztlich die Summe aus dem Gesamt-Erdungswiderstand und dem jeweiligen Kontaktwiderstand *R_{E}* + *R_{ME}* ermittelt und im Ergebnis relevante Informationen über den wenigstens einen Aufstellungsparameter erhalten werden. Dabei können die beiden für die Kontaktplatten 23 jeweils separat durchgeführten Messungen gegeneinander plausibilisiert werden. In einem dritten Funktionszustand sind bevorzugt beide Schalter 51, 53 geöffnet; es kann dann unmittelbar die Impedanz zwischen den Kontaktplatten, insbesondere als *2R_{ME}*, ermittelt werden. Aus einer Kombination der Messungen in dem ersten Funktionszustand, dem zweiten Funktionszustand und dem dritten Funktionszustand können schließlich auch der Kontaktwiderstand *R_{ME}* und der Gesamt-Erdungswiderstand *R_{E}* alleine erhalten werden. Insgesamt können bei diesem zweiten Ausführungsbeispiel der Messvorrichtung 25 somit mehrere parasitäre Komponenten mit höchster Präzision erfasst werden. Zu dem Zweck der Überwachung der Berührsicherheit im engeren Sinn, d.h. insbesondere zur Messung der mindestens einen elektrischen Messgröße zwischen der Berührstelle 15 und den Kontaktplatten 23, sind bevorzugt in einem vierten Funktionszustand beide Schalter 51, 53 geschlossen.

Bevorzugt sind die Schalter 51, 53 als Halbleiterschalter ausgebildet.

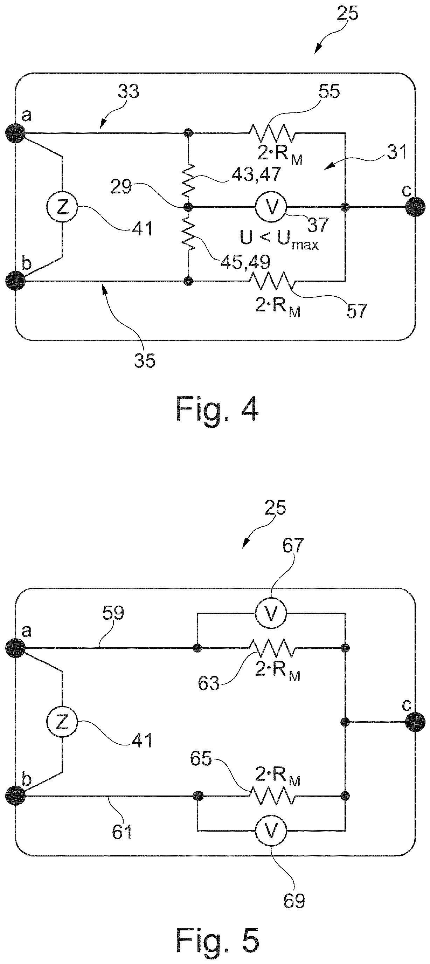

Fig. 4 zeigt eine schematische Darstellung eines dritten Ausführungsbeispiels der Messvorrichtung 25.

Bei dem ersten Ausführungsbeispiel gemäß Figur 2 und dem zweiten Ausführungsbeispiel gemäß Figur 3 der Messvorrichtung 25 ist der Messwiderstand 36, der zur Abgrenzung als ein erster Messwiderstand 36 bezeichnet wird, quasi in die Messschaltung 31 integriert.

Bei dem dritten Ausführungsbeispiel der Messvorrichtung 25 gemäß Figur 4 ist demgegenüber die erste Kontaktplatte 23.1, das heißt hier insbesondere der erste Anschluss a, elektrisch parallel zu dem ersten Verbindungsleiter 33 und zu der Messschaltung 31 über einen zweiten Messwiderstand 55 mit der Berührstelle 15, das heißt insbesondere mit dem dritten Anschluss c, verbunden, und die zweite Kontaktplatte 23.2, das heißt insbesondere der zweite Anschluss b, ist elektrisch parallel zu dem zweiten Verbindungsleiter 35 und der Messschaltung 31 über einen dritten Messwiderstand 57 mit der Berührstelle 15, das heißt insbesondere mit dem dritten Anschluss c, verbunden. Aufgrund der elektrischen Parallelschaltung des zweiten Messwiderstands 55 und des dritten Messwiderstands 57 weisen diese bevorzugt jeweils im Vergleich zu dem ersten Messwiderstand 36 den doppelten Widerstandswert *2R_{M}* auf.

Die Entkopplungsvorrichtungen 43, 45 sind hier beispielhaft - analog zu dem ersten Ausführungsbeispiel gemäß Figur 2 - als Entkoppelwiderstände 47, 49 dargestellt. Es ist aber auch bei dem dritten Ausführungsbeispiel selbstverständlich möglich, die Entkopplungsvorrichtungen 43, 45 als Spulen, insbesondere Drosseln, auszubilden.

Im Vergleich zu dem ersten Ausführungsbeispiel gemäß Figur 2 ergibt sich bei dem dritten Ausführungsbeispiel gemäß Figur 4 der Vorteil, dass zum einen die Entkoppelwiderstände 47, 49 hochohmig ausgebildet werden können, wobei auch die Messwiderstände 55, 57 gemäß Figur 4 höhere Widerstandswerte aufweisen als die in Figur 2 dargestellten Entkoppelwiderstände 47, 49 des ersten Ausführungsbeispiels. Somit kann die Impedanz zwischen den Kontaktplatten 23 bei dem dritten Ausführungsbeispiel gemäß Figur 4 mit höherer Genauigkeit gemessen werden als bei dem ersten Ausführungsbeispiel gemäß Figur 2. Bei diesem sollten nämlich die Entkoppelwiderstände 47, 49 sehr viel kleiner gewählt werden als der erste Messwiderstand 36, um die Messung der mindestens einen elektrischen Messgröße nicht zu stark zu beeinflussen, wobei dies aber wiederum zur Folge hat, dass die Impedanz zwischen den Kontaktplatten 23 nur mit vergleichsweise geringer Genauigkeit bestimmt werden kann, da die Messung durch die parallelgeschalteten Entkoppelwiderstände 47, 49 dominiert wird.

Fig. 5 zeigt eine schematische Darstellung eines vierten Ausführungsbeispiels der Messvorrichtung 25. Bei dem vierten Ausführungsbeispiel ist der erste Anschluss a und damit die erste Kontaktplatte 23.1 über einen ersten Messleiter 59 mit dem dritten Anschluss c und damit der Berührstelle 15 verbunden, und der zweite Anschluss b und damit die zweite Kontaktplatte 23.2 ist über einen zweiten Messleiter 61 elektrisch mit dem dritten Anschluss c und damit der Berührstelle 15 verbunden. In dem ersten Messleiter 59 ist ein vierter Messwiderstand 62 angeordnet, und in dem zweiten Messleiter 61 ist ein fünfter Messwiderstand 65 angeordnet. Die Messvorrichtung 25 weist in diesem Fall zwei Spannungsmessvorrichtungen, in Abgrenzung zu der einzigen - ersten - Spannungsmessvorrichtung 37 der vorhergehenden Ausführungsbeispiele als zweite Spannungsmessvorrichtung 67 und als dritte Spannungsmessvorrichtung 69 bezeichnet, auf, wobei die zweite Spannungsmessvorrichtung 67 angeordnet und eingerichtet ist, um eine über dem vierten Messwiderstand 63 abfallende elektrische Spannung zu messen, und wobei die dritte Spannungsmessvorrichtung 69 angeordnet und eingerichtet ist, um eine zweite, über dem fünften Messwiderstand 65 abfallende elektrische Spannung zu messen. Aufgrund der elektrischen Parallelschaltung des vierten Messwiderstand 63 und des fünften Messwiderstand 65 weisen diese wiederum im Vergleich zu dem einzigen ersten Messwiderstand 36 den doppelten Widerstandswert *2R_{M}* auf. Die Entkopplung der Impedanzmessung mit der Impedanz-Messvorrichtung 41 erfolgt hier unmittelbar über die Messwiderstände 63, 65 selbst. Auch auf diese Weise ist vorteilhaft eine genauere Messung der Impedanz möglich als bei dem ersten Ausführungsbeispiel gemäß Figur 2. Die zweifache Spannungsmessung über die zweite Spannungsmessvorrichtung 67 und die dritte Spannungsmessvorrichtung 69 ermöglicht vorteilhaft eine Plausibilisierung der Messwerte gegeneinander.

## Patentansprüche

1. Mobile elektrische Energiebereitstellungsvorrichtung (1), mit
- mindestens einem Energieversorgungsanschluss (3) zur Entnahme von Energie aus der Energiebereitstellungsvorrichtung (1),
- einer Bodenerdungsvorrichtung (5), die eingerichtet ist, um an einem Aufstellort (7) der Energiebereitstellungsvorrichtung (1) mit einem Boden (9) des Aufstellorts (7) zusammenzuwirken, um eine Erdung für die Energiebereitstellungsvorrichtung (1) bereitzustellen, und mit
- einer Berührsicherheits-Überwachungsvorrichtung (13), die eingerichtet ist, um mindestens eine an der Energiebereitstellungsvorrichtung (1) angeordnete oder mit der Energiebereitstellungsvorrichtung (1) elektrisch verbundene Berührstelle (15) auf Berührsicherheit zu überwachen.

2. Energiebereitstellungsvorrichtung (1) nach Anspruch 1, wobei die Bodenerdungsvorrichtung (5) mindestens eine Erdungs-Standfläche (19) aufweist, die angeordnet und eingerichtet ist, um an dem Aufstellort (7) in berührendem Kontakt mit dem Boden (9) zu sein.

3. Energiebereitstellungsvorrichtung (1) nach einem der vorhergehenden Ansprüche, wobei die Berührsicherheits-Überwachungsvorrichtung (13) mindestens eine Kontaktplatte (23) aufweist, die angeordnet und eingerichtet ist, um an dem Aufstellort (7) in berührendem Kontakt mit dem Boden (9) zu sein, wobei die Berührsicherheits-Überwachungsvorrichtung (13) vorzugsweise eine Messvorrichtung (25) aufweist, die einerseits mit der mindestens einen Kontaktplatte (23) und andererseits mit der mindestens einen Berührstelle (15) wirkverbunden ist.

4. Energiebereitstellungsvorrichtung (1) nach einem der vorhergehenden Ansprüche, wobei die Messvorrichtung (25) eingerichtet ist, um mindestens eine elektrische Messgröße zwischen der mindestens einen Berührstelle (15) und der mindestens einen Kontaktplatte (23) zu messen, wobei die mindestens eine elektrische Messgröße ausgewählt ist aus einer Gruppe, bestehend aus einer Spannung und einer Stromstärke.

5. Energiebereitstellungsvorrichtung (1) nach einem der vorhergehenden Ansprüche, wobei die Berührsicherheits-Überwachungsvorrichtung (13) eingerichtet ist, um einen Messwert der mindestens einen elektrischen Messgröße mit einem Schwellenwert zu vergleichen, und um die Berührsicherheit anhand des Vergleichs zu bewerten.

6. Energiebereitstellungsvorrichtung (1) nach einem der vorhergehenden Ansprüche, wobei die Messvorrichtung (25) eingerichtet ist, um die mindestens eine elektrische Messgröße zeitabhängig zu erfassen, und wobei die Berührsicherheits-Überwachungsvorrichtung (13) eingerichtet ist, um die Berührsicherheit anhand der zeitabhängig erfassten mindestens einen elektrischen Messgröße zu bewerten.

7. Energiebereitstellungsvorrichtung (1) nach einem der vorhergehenden Ansprüche, wobei die Berührsicherheits-Überwachungsvorrichtung (13) als die mindestens eine Kontaktplatte (23) zwei Kontaktplatten (23.1, 23.2) aufweist, die voneinander beabstandet angeordnet und eingerichtet sind, um an dem Aufstellort (7) in berührendem Kontakt mit dem Boden (9) zu sein, wobei die beiden Kontaktplatten (23.1, 23.2) vorzugsweise elektrisch parallel zueinander mit der Messvorrichtung (25) verbunden sind.

8. Energiebereitstellungsvorrichtung (1) nach Anspruch 7, wobei die Messvorrichtung (25) mit den beiden Kontaktplatten (23.1, 23.2) wirkverbunden und eingerichtet ist, um eine Impedanz zwischen den Kontaktplatten (23.1, 23.2) zu messen.

9. Energiebereitstellungsvorrichtung (1) nach einem der vorhergehenden Ansprüche, wobei die Energiebereitstellungsvorrichtung (1) als eine Vorrichtung ausgebildet ist, die ausgewählt ist aus einer Gruppe, bestehend aus: Einem elektrischen Energiespeicher, einer Ladesäule, insbesondere zum Laden elektrisch angetriebener Kraftfahrzeuge, und einem elektronischen Leistungswandler.

10. Energiebereitstellungsvorrichtung (1) nach einem der vorhergehenden Ansprüche, wobei der Energieversorgungsanschluss (3) ein Ladekabel (4) aufweist, das einen Schutzleiter (8) umfasst, wobei die Berührsicherheits-Überwachungsvorrichtung (13), insbesondere die Messvorrichtung (25), mit dem Schutzleiter (8) elektrisch verbunden ist.

11. Energiebereitstellungsvorrichtung (1) nach einem der vorhergehenden Ansprüche, wobei die Messvorrichtung (25) einen gemeinsamen Kontaktpunkt (29) sowie eine Messschaltung (31) aufweist, wobei eine erste Kontaktplatte (23.1) der beiden Kontaktplatten (23) über einen ersten Verbindungsleiter (33) mit dem gemeinsamen Kontaktpunkt (29) elektrisch verbunden ist, wobei eine zweite Kontaktplatte (23.2) der beiden Kontaktplatten (23) über einen zweiten Verbindungsleiter (35) mit dem gemeinsamen Kontaktpunkt (29) elektrisch verbunden ist, und wobei die Messschaltung (31) mit der mindestens einen Berührstelle (15) und mit dem gemeinsamen Kontaktpunkt (29) elektrisch verbunden und eingerichtet ist, um die mindestens eine elektrische Messgröße zwischen der mindestens einen Berührstelle (15) und dem gemeinsamen Kontaktpunkt (29) zu messen.

12. Energiebereitstellungsvorrichtung (1) nach Anspruch 11, wobei die Messvorrichtung (25) eingerichtet ist, um die Impedanz zwischen den beiden Kontaktplatten (23.1, 23.2), insbesondere zwischen dem ersten Verbindungsleiter (33) und dem zweiten Verbindungsleiter (35), zu messen, wobei in dem ersten Verbindungsleiter (33) eine erste Entkopplungsvorrichtung (43) angeordnet ist, und wobei in dem zweiten Verbindungsleiter (35) eine zweite Entkopplungsvorrichtung (45) angeordnet ist.

13. Energiebereitstellungsvorrichtung (1) nach Anspruch 12, wobei zumindest eine Entkopplungsvorrichtung (43, 45), ausgewählt aus der ersten Entkopplungsvorrichtung (43) und der zweiten Entkopplungsvorrichtung (45), als
- Entkoppelwiderstand (47, 49), oder
- Schalter (51, 53)
ausgebildet ist.

14. Energiebereitstellungsvorrichtung (1) nach einem der Ansprüche 11 oder 12, wobei
- ein erster Messwiderstand (36) in die Messschaltung (31) integriert ist, oder wobei
- die erste Kontaktplatte (23.1) elektrisch parallel zu dem ersten Verbindungsleiter (33) und der Messschaltung (31) über einen zweiten Messwiderstand (55) mit der mindestens einen Berührstelle (15) verbunden ist, wobei die zweite Kontaktplatte (23.2) elektrisch parallel zu dem zweiten Verbindungsleiter (35) und der Messschaltung (31) über einen dritten Messwiderstand (57) mit der mindestens einen Berührstelle (15) verbunden ist.

15. Energiebereitstellungsvorrichtung (1) nach einem der Ansprüche 1 bis 10, wobei eine erste Kontaktplatte (23.1) der beiden Kontaktplatten (23.1, 23.2) über einen ersten Messleiter (33) elektrisch mit der mindestens einen Berührstelle (15) verbunden ist, wobei eine zweite Kontaktplatte (23.2) der beiden Kontaktplatten (23.1, 23.2) über einen zweiten Messleiter (35) elektrisch mit der mindestens einen Berührstelle (15) verbunden ist, wobei in dem ersten Messleiter (33) ein vierter Messwiderstand (63) angeordnet ist, wobei in dem zweiten Messleiter (35) ein fünfter Messwiderstand (65) angeordnet ist, und wobei die Messvorrichtung (25) eingerichtet ist, um eine erste, über dem vierten Messwiderstand (63) abfallende elektrische Spannung zu messen, und um eine zweite, über dem fünften Messwiderstand (65) abfallende elektrische Spannung zu messen.
